(19)

Europäisches Patentamt

European Patent Office

Office européen des brevets

(11)  EP 4 610 410 A1

(12)  EUROPEAN PATENT APPLICATION
published in accordance with Art. 153(4) EPC

(43) Date of publication:
03.09.2025  Bulletin 2025/36

(21) Application number: 23882656.4

(22) Date of filing: 24.10.2023

(51) International Patent Classification (IPC):
C30B 15/14 (2006.01)    H05B 6/06 (2006.01)

(52) Cooperative Patent Classification (CPC):
C30B 15/14; H05B 6/06

(86) International application number:
PCT/JP2023/038408

(87) International publication number:
WO 2024/090451 (02.05.2024 Gazette 2024/18)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority:  24.10.2022  JP 2022169953

(71) Applicants:
• C & A Corporation
  Sendai-shi, Miyagi 980-0811 (JP)
• Tohoku University
  Sendai-shi, Miyagi 980-8577 (JP)

(72) Inventors:
• TOMIDA Taketoshi
  Sendai-shi, Miyagi 980-0811 (JP)

• YOSHIKAWA Akira
  Sendai-shi, Miyagi 980-8577 (JP)
• KOCHURIKHIN Vladimir
  Sendai-shi, Miyagi 980-0811 (JP)
• GUSHCHINA Liudmila
  Sendai-shi, Miyagi 980-0811 (JP)
• SHOJI Yasuhiro
  Sendai-shi, Miyagi 980-0811 (JP)
• TAKAHASHI Isao
  Sendai-shi, Miyagi 980-0811 (JP)
• KAMADA Kei
  Sendai-shi, Miyagi 980-8577 (JP)

(74) Representative: Plasseraud IP
104 Rue de Richelieu
CS92104
75080 Paris Cedex 02 (FR)

(54) **CRYSTAL MANUFACTURING METHOD, HIGH FREQUENCY HEATING DEVICE, AND CRYSTAL MANUFACTURING DEVICE**

(57)    The high-frequency heating device includes at least a phase difference detector, a frequency controller, an inverter, and an LCR circuit, and the phase difference detector detects the phase difference between the high-frequency voltage generated by the frequency controller and the high-frequency current flowing through the LCR circuit, and the inverter updates the driving frequency of the high-frequency voltage based on the phase difference to control the current in the LCR circuit.

FIG. 1

EP 4 610 410 A1

**Description**

TECHNICAL FIELD

The present invention relates to a crystal production method, a high-frequency heating device, and a crystal producing apparatus. This application claims priority based on Japanese Patent Application No. 2022-169953 filed in Japan on October 24, 2022, the contents of which are incorporated herein by reference.

BACKGROUND ART

Toward the construction of the next-generation digital infrastructure, energy saving is required for power devices that perform power conversion, such as home appliances, electric vehicles, industrial machines, and renewable energy. Conventionally, power devices using silicon have been mainstream, but power semiconductor materials with smaller energy conversion losses than silicon are required. Research and development of such materials, such as silicon carbide (SiC), gallium nitride (GaN), and gallium oxide, has been conducted. Among them, gallium oxide has attracted attention as a next-generation power semiconductor material because it has a high Variga performance index, so there is little resistance loss, and a large energy band gap, so that it has high pressure resistance. Furthermore, gallium oxide, especially $\beta$-$Ga_2O_3$, melts at a lower temperature than silicon carbide and gallium nitride, so single crystal growth from the melt is also possible, and therefore cost reduction is expected. For this reason, gallium oxide is expected to be a fundamental technology from the viewpoint of single crystal growth technology of high-melting point compounds.
Currently, the Edge-Defined Film-fed Growth (EFG) method is known as a technique for growing single crystals of gallium oxide, and is disclosed in Patent Document 1 and Non-Patent Document 1. By using the EFG method, stable crystals can be obtained.
In response to the above problems, the skull melt method, in which single crystals are grown by directly applying an electromagnetic field to a base material for crystal growth using an induction coil, has been researched and developed for a long time. Patent Documents 2 and 3 disclose a cold crucible suitable for the skull melt method and an example of single crystal production using the same. Patent Document 4 discloses a gallium oxide cold crucible and a method for producing a gallium oxide single crystal by the skull melt method using the same. Patent Document 5 discloses the configuration of an apparatus for producing single crystals by the skull melt method.

CITATION LIST

PATENT DOCUMENT

Patent Document 1: Japanese Patent Application Publication No. 2006-312571
Patent Document 2: U.S. Patent Application Publication No. 4,049,384
Patent Document 3: Japanese Patent Application Publication No. 60-2876
Patent Document 4: Japanese Patent Application Publication No. 2017-61396
Patent Document 5: Japanese Patent Application Publication No. 2018-191426

NON-PATENT DOCUMENT

Non-Patent Document 1: Hideo Aida et al., Growth of $\beta$-Ga2O3 single crystals by the Edge-Defined, Film Fed Growth Method, Jpn. Journal of Applied Physics, Vol.47, No.11, 2008, pp.8506-8509

SUMMARY OF INVENTION

TECHNICAL PROBLEM

However, the techniques described in Patent Document 1 and Non-Patent Document 1 require a larger crucible to increase the size of the crystals, and the crucible material that can be used at the melting point of gallium oxide is an expensive material such as iridium, making it difficult to reduce costs. This problem has not been solved yet.
Furthermore, Patent Documents 2 to 5 do not disclose specific conditions for producing the single crystal.
Furthermore, although research and development into crystal growth using the skull melt method is being conducted, industrial mass production and commercialization has not yet been realized.
Therefore, the present inventors have studied a production method and a production apparatus for gallium oxide crystals by the skull melt method using a cold crucible, and have extracted manufacturing problems.

The melting point of gallium oxide is approximately 1,800°C. In order to identify the conditions required for heating using an induction coil, various experiments were conducted and theoretical considerations were carried out. As a result, it was confirmed that in order to directly heat a raw material by induction heating, the frequency $f$(Hz) of the magnetic field, the resistivity $\rho$ ($\Omega \cdot$m) of the raw material to be heated, and the volume $D$(m$^3$) of the raw material must satisfy the relationship expressed by the following equation (1).

$$f \geqq 3 \times 10^6 (\rho/D^2) \qquad \text{Equation (1)}$$

Since oxides have a large resistivity $\rho$, it is necessary to apply a high frequency magnetic field $f$ to heat the oxide raw material. For example, the resistivity $\rho$ of an $Al_2O_3$ melt is $1.0 \times 10^{-3}$, and when D is 0.1 m$^3$, a frequency $f$ on the order of several hundred kHz or more is required.

Therefore, the inventors succeeded in melting gallium oxide by applying a high-frequency magnetic field of about 400 kHz, but faced the problem that it was difficult to maintain a stable heating state due to large fluctuations in the high-frequency voltage and high-frequency current after the gallium oxide was melted.

The fluctuations in the RF voltage and RF current are due to the change in impedance of the raw material as it is heated and melted. The change in impedance of the raw material is thought to be influenced by the difference in resistivity between the solid and molten gallium oxide, the temperature dependence of resistivity, and the melt and its volume change.

The induction heating coil is driven by an LCR resonant circuit, and the impedance of the melt is connected as an external load to the LCR circuit, so a sudden change in the impedance of the melt causes a sudden change in the impedance of the external load, and the driving current, driving voltage, and driving frequency flowing through the LCR circuit also change in conjunction. At this time, if the change is away from the resonance point, the molten gallium oxide solidifies and cannot maintain the molten state. On the other hand, if the change is closer to the resonance point, high-frequency noise is generated, an overcurrent flows in the driving circuit, and the transistor may be damaged, and stable heating control cannot be achieved.

Another phenomenon is an increase in electromagnetic noise. There are various possible causes for electromagnetic noise, but it is believed to be due to noise generated when transistors are switched on and off due to the use of a high frequency of 400 kHz. Therefore, it is assumed that this phenomenon is common to melting stepes of high melting point oxides that use high frequencies.

For the reasons described above, when controlling the heating of the raw material for crystal growth in the melting step and in the crystal growing step, there was a problem that normal current and voltage control alone was unstable due to large fluctuations in current and voltage, making it impossible to provide stable heating control.

An object of the present invention is to stabilize the unstable heating control during melting and crystal growth of high-melting-point raw materials using induction heating, which is the above-mentioned problem.

Therefore, the inventors conducted extensive research to achieve not only output control (current control or voltage control) but also more precise control, and discovered that a stable heating process can be achieved by detecting the phase difference between the voltage and current (the phase of the current lags behind the phase of the voltage) and controlling it by feeding back to the frequency of the high-frequency magnetic field at the threshold value.

In addition, they found that by configuring a high-frequency heating device with a phase difference detector that detects the phase difference between the high-frequency voltage and high-frequency current, a frequency controller that compares the detected phase difference with a threshold value and feeds it back to the heating frequency, an inverter that generates the frequency-controlled high-frequency voltage, and an LCR circuit that performs induction heating, it is possible to detect the phase difference between the high-frequency voltage and high-frequency current and control the frequency.

Furthermore, the inventors discovered that in the above-mentioned high-frequency heating device, stable feedback control can be realized at low cost by generating high frequency waves by controlling the gate voltage of the transistor in the inverter using software with a frequency controller including a computer.

SOLUTION TO PROBLEM

The gist of the present invention is as follows.

[1] A crystal production method according to one embodiment of the present invention is a crystal production method using a high-frequency heating device equipped with an LCR circuit including a heating coil for heating a raw material, the crystal production method including: a melting step of melting a raw material; and a crystal growing step of growing a crystal, wherein heating is performed by controlling a driving frequency of induction heating in at least one of the melting step and the crystal growing step.

[2] In the crystal production method described in [1] above, the melting step may be a step of heating and melting the raw material placed inside the heating coil by a high-frequency magnetic field generated by applying a high-frequency voltage and a high-frequency current generated by the high-frequency heating device to the heating coil included in the LCR circuit, the crystal growing step may be a step of growing a crystal by contacting a seed crystal with a raw material melt in which the raw material is molten, and at least in one of the melting step and the crystal growing step, a temperature distribution of the raw material melt is controlled by controlling the driving frequency of the high-frequency voltage applied to the LCR circuit based on a phase difference between the high-frequency voltage and the high-frequency current, or a phase difference between a gate voltage of a transistor that determines the frequency of the high-frequency heating device and the high-frequency current.

[3] In the crystal production method according to the above [1] or [2], in the melting step, the raw material may be heated by the high frequency magnetic field to melt the raw material.

[4] In the crystal production method according to any one of [1] to [3] above, the drive frequency may be shifted to a higher or lower frequency side with respect to a resonant frequency of the LCR circuit.

[5] In the crystal production method according to any one of [1] to [3] above, the driving frequency used in the crystal growing step may be farther away from a resonant frequency of the LCR circuit than the driving frequency used in the melting step.

[6] A high-frequency heating device according to another aspect of the present invention is a high-frequency heating device including, at least: a phase difference detector; a frequency controller; an inverter; and an LCR circuit, wherein the phase difference detector is configure to detect the phase difference between the high-frequency voltage generated by the frequency controller and the high-frequency current flowing through the LCR circuit, or the phase difference between the high-frequency voltage applied to the LCR circuit and the high-frequency current flowing through the LCR circuit, and the inverter is configured to update the drive frequency of the high-frequency voltage based on the phase difference to control the current of the LCR circuit.

[7] In the high-frequency heating device described in [6] above, the phase difference detector may include a phase frequency detector, an analog phase detector, or a digital phase detector that detects the phase difference.

[8] In the high-frequency heating device described in [6] or [7] above, the inverter may include a plurality of transistors in parallel that operate as switching elements, and the frequency controller is configured to generate a reference waveform to be updated by the frequency controller based on the phase difference detected by the phase difference detector, and control the transistor with the voltage of the reference waveform to be updated, thereby generating a high frequency voltage and a high frequency current whose drive frequency to be applied to the LCR circuit is updated.

[9] The frequency of the high-frequency voltage generated by the high-frequency heating device according to any one of [6] to [8] above may be 20 MHz or less.

[10] The high-frequency heating device according to any one of [6] to [9] above may include a Rogowski type or a wound type current sensor, wherein the high frequency current flowing through the LCR circuit is detected by the current sensor.

[11] A crystal producing apparatus according to yet another embodiment of the present invention is a crystal producing apparatus for growing crystals using a raw material melt, including: a high-frequency heating device having an LCR circuit containing a heating coil for heating the raw material; and a coolable basket for holding the raw material, wherein a temperature of the melt is controlled by controlling a frequency of a high-frequency voltage applied to the heating coil arranged outside the basket.

[12] The crystal producing apparatus described in [11] above may include: a rod having one end insertable into an inside of the basket from above, wherein a seed crystal is held at the one end, and the rod is configured to be movable relative to the basket from the one end to another end of the rod.

[13] The crystal producing apparatus according to [12] above may further include a rotation mechanism configured to rotate at least either the rod or the raw material about a central axis of the rod in the extension direction as a rotation axis.

ADVANTAGEOUS EFFECTS OF INVENTION

According to the present invention, the heating process can be stabilized.

BRIEF DESCRIPTION OF DRAWINGS

[Figure 1] It is a configuration diagram of a high-frequency heating device according to an embodiment of the present invention.

[Figure 2] The panel (A) of Figure 2 is a schematic circuit diagram of an inverter, and the panel (B) of Figure 2 is a schematic diagram of a high frequency generated by a transistor.

[Figure 3] It is a diagram showing an outline of a part of the circuit of an inverter, including an LCR circuit including a heating coil, in the embodiment.

[Figure 4] The panel (A) of Figure 4 is a conceptual diagram for explaining a phase difference between an output current waveform and a reference waveform, and the panel (B) of Figure 4 is a waveform diagram showing an example of an output current waveform and an output voltage waveform.

[Figure 5] It is a graph showing the time variations of the drive frequency, phase difference, current, and voltage when frequency control is performed based on the phase difference in a crystal growing step in a crystal production method according to one embodiment of the present invention.

[Figure 6] It is a graph showing the phase difference, driving frequency, current, and voltage when frequency control is performed based on the phase difference in the melting step of the crystal production method according to one embodiment of the present invention.

[Figure 7] It is a graph showing the phase difference, driving frequency, current, and voltage when frequency control is performed based on the phase difference in a crystal growing step in a crystal production method according to one embodiment of the present invention.

DESCRIPTION OF EMBODIMENTS

Hereinafter, a crystal production method, a high-frequency heating device, and a crystal producing apparatus according to an embodiment of the present invention will be described with reference to the accompanying drawings. Note that the present invention is not limited to the following embodiment.

<High-frequency heating device 1>

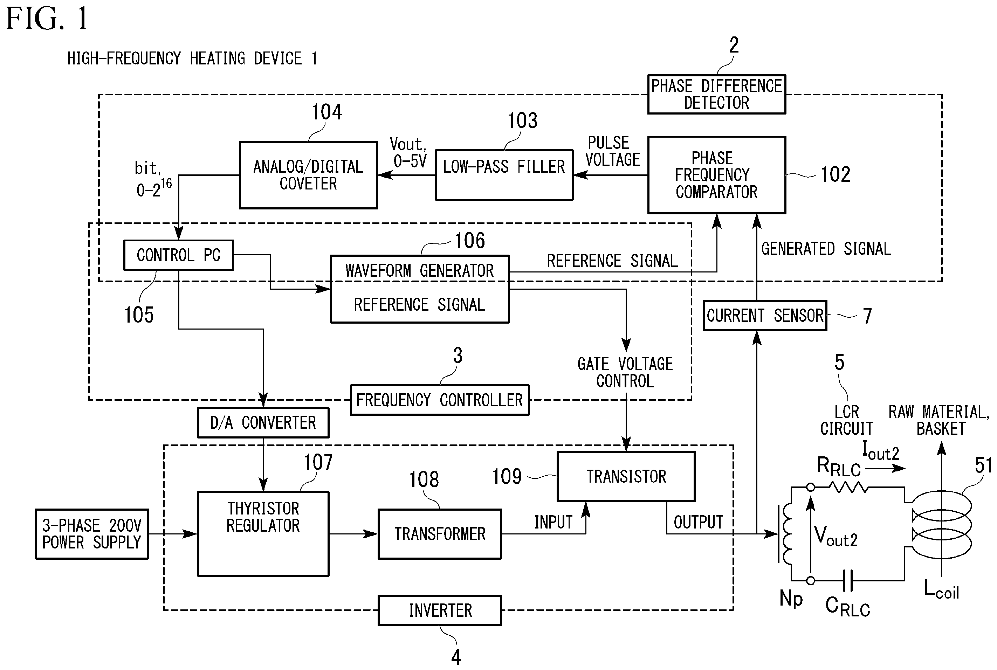

A high-frequency heating device 1 according to an embodiment of the present invention will be described with reference to Figure 1. Figure 1 is a configuration diagram of the high-frequency heating device according to this embodiment. The high-frequency heating device 1 according to this embodiment includes at least a phase difference detector 2, a frequency controller 3, an inverter 4, and an LCR circuit 5.

(Phase difference detection part 2)

The phase difference detector 2 detects the phase difference between the high frequency voltage generated by the frequency controller 3 and the high frequency current flowing through the LCR circuit 5. The phase difference here is the difference between the phase of the voltage of the reference waveform applied to the gate of the transistor 109 and the phase of the operating current as shown in Figure 1. This phase difference also coincides with the difference between the phase of the operating voltage, which is the output of the transistor 109 switched by the reference waveform input to the gate of the transistor 109, and the phase of the operating current. Therefore, the phase difference detector 2 detects the difference between the phase of the voltage of the reference waveform applied to the gate of the transistor 109 and the phase of the operating current, or the difference between the phase of the operating voltage of the transistor 109 and the phase of the operating current. As shown in Figure 1, the phase difference detector 2 includes at least a phase comparator 102, a low pass filter 103, and an A/D converter 104, and includes a part of a computer 105.

[Phase comparator 102]

The phase comparator 102 detects the phase difference between two input signals. In detail, the phase comparator 102 converts the phase difference between the output current waveform of the LCR circuit 5 and a reference waveform generated by the arbitrary waveform generator 106 into a voltage and outputs it as an error signal. The phase comparator 102 may be a phase frequency detector, an analog phase detector, or a digital phase detector.

[Low-pass filter 103]

The low-pass filter 103 smoothes the error signal (pulse) corresponding to the phase difference output by the phase comparator 102, and outputs it as a DC voltage. For example, a DC voltage of 0 to 5 V is output by the low-pass filter 103. This low-pass filter 103 is sometimes called a loop filter.

[A/D converter 104]

The A/D converter 104 converts the DC voltage output by the low-pass filter 103 into a digital signal.

[Computer 105]

The computer 105 detects the difference between the phase of the voltage of a reference waveform applied to the gate of the transistor 109 described later and the phase of the operating current, or the difference between the phase of the operating voltage of the transistor 109 and the phase of the operating current (phase difference), compares it with a set threshold, and when the threshold is crossed (changing from a value above the threshold to a value below the threshold, or changing from a value below the threshold to a value equal to or above the threshold), increases or decreases the driving frequency by a preset change width, updates the driving frequency, and inputs a control signal for generating the updated driving frequency to the arbitrary waveform generator 106. The computer 105 also compares the detected phase difference with a set threshold, and when the phase difference crosses the threshold, updates the driving frequency by a certain frequency fluctuation amount, and inputs a signal for generating the updated driving frequency to the arbitrary waveform generator 106. The certain frequency fluctuation amount may be a width previously determined from the actual manufacturing conditions. The phase difference threshold here is a threshold when the driving frequency is brought close to the resonant frequency by a certain frequency fluctuation amount, and there are two thresholds, an upper threshold and a lower threshold. In feedback control, when the phase difference becomes larger than the set phase difference value, this set phase difference value is set as the upper threshold value of the phase difference. Also, when the phase difference becomes smaller than the set phase value, the drive frequency is moved away from the resonant frequency by a certain amount of frequency fluctuation. The set phase difference value at this time is set as the lower threshold value of the phase difference. The upper threshold value and the lower threshold value are collectively referred to as the phase difference threshold value. Also, the frequency fluctuation amount refers to the amount by which the drive frequency is changed when it deviates from the set phase difference threshold value.
Although a phase frequency detector has been given above as the phase difference detector 2, the phase difference detector 2 may be an analog phase detector or a digital phase detector.

(Frequency controller 3)

The frequency controller 3 includes at least an arbitrary waveform generator 106 and a part of a computer 105 as shown in Figure 1. The frequency controller 3 generates an arbitrarily set waveform (frequency pulse) by the computer 105 and the arbitrary waveform generator 106.

[Arbitrary Waveform Generator 106]

The arbitrary waveform generator 106 generates a reference waveform. The arbitrary waveform generator 106 also generates a waveform with a drive frequency updated by a control signal input from the computer 105 and outputs it to the gate of the transistor 109. At the same time, it also outputs it to the phase comparator 102 as a reference signal. The arbitrary waveform generator 106 generates a frequency pulse based on the phase difference detected by the phase difference detector 2. The computer 105 controls the transistor 109 with the updated frequency pulse to generate a high-frequency voltage with an updated drive frequency to be applied to the LCR circuit 5.

(Inverter 4)

The inverter 4 generates a high-frequency voltage. The high-frequency voltage generated by the inverter 4 drives the LCR circuit 5. As a result, a high-frequency current flows from the LCR circuit 5 to the heating coil 51, and the raw material is heated. As shown in Figure 1, the inverter 4 includes at least a thyristor regulator 107, a step-up transformer 108, and a plurality of transistors 109.

[Thyristor regulator 107]

The thyristor regulator 107 controls the AC current output from the power supply.

[Step-up transformer 108]

The step-up transformer 108 increases the voltage output from the power supply.

[Transistor 109]

The transistor 109 operates as a switching element. The transistor 109 applies a high-frequency voltage of a drive frequency to the LCR circuit 5. The transistor 109 is preferably made of SiC. The transistor preferably has a structure of a metal-oxide-semiconductor field-effect transistor (MOSFET), a metal-semiconductor field-effect transistor (MESFET), or an insulated gate bipolar transistor (IGBT).

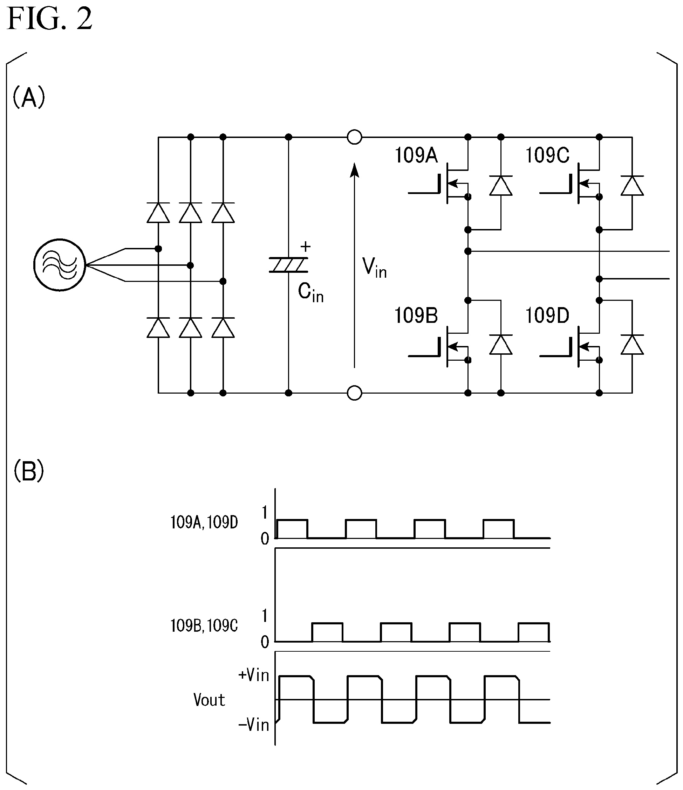

The panel (A) of Figure 2 shows a schematic circuit diagram of the inverter, and the panel (B) of Figure 2 shows a schematic diagram of the high frequency generated by the transistors. As shown in the panel (A) of Figure 2, the inverter 4 includes transistors 109 arranged in parallel. The inverter 4 rectifies the three-phase current output from the thyristor regulator 107 with a bridge diode, stores electric charge in a capacitor, and passes the current from the capacitor to the transistors 109 as a direct current (AC/DC conversion). As a result, a voltage (gate voltage) corresponding to the electric charge stored in each transistor 109 is applied, and the transistor 109 functions as a switching element. The frequency control is performed by applying a high frequency waveform generated by the arbitrary waveform generator 106 to the gate of the transistor 109 in response to a frequency control signal output from the computer 105 to control the gate voltage. When the gate voltage exceeds the threshold voltage Vth of the transistor 109, the transistor 109 is turned on (turned on). **In** the inverter circuit shown in the panel (A) of Figure 2, a transistor 109A is combined with a transistor 109D, and a transistor 109B is combined with a transistor 109C to form a rectangular wave that turns on and off. As shown in the panel (B) of Figure 2, the frequency of the output voltage $V_{out}$ is controlled by controlling the gate voltage of each transistor 109. By the above frequency control, the transistor 109 outputs a rectangular wave frequency (drive frequency) in the range of several hundred kHz to 10 MHz. The drive frequency output by the transistor 109 is preferably 20 MHz or less. This allows a material with a higher melting point to melt. The drive frequency output by the transistor 109 is more preferably 10 MHz or less, and even more preferably 6 MHz or less. The drive frequency output by the transistor 109 is preferably 100 kHz or more, and more preferably 300 kHz or more. The duty of the rectangular wave can be adjusted, but here a duty of 40% is generated.

The transistor 109 is preferably made of SiC. SiC can achieve high voltage resistance and can reduce switching loss and series resistance loss, allowing for higher output and precise frequency control, and can precisely control the temperature distribution even with a raw material having a high melting point. As described above, a wide range of frequencies can be achieved, making it possible to adjust the frequency according to the size of the melt, the temperature dependency of the resistivity, and the resistivity difference between solid and liquid.

(LCR circuit 5)

The LCR circuit 5 is a circuit (LCR series circuit) in which a coil, a capacitor, and a resistor are connected in series. The LCR circuit 5 includes a heating coil 51. The heating coil 51 corresponds to the coil in the LCR circuit. The LCR circuit 5 removes harmonic components of the square wave and forms a fundamental sinusoidal wave current.

An induced current generated in the LCR circuit 5 by the high frequency current generated by the high frequency heating device 1 flows in the heating coil 51, generating a magnetic field around the heating coil 51. Inside the heating coil 51, the raw material placed in a basket (not shown) contains a conductive material, and induction heating begins from the conductive material. Eddy currents flow in the raw material in a direction that prevents changes in the magnetic field that change in response to changes in the high frequency current, and Joule heat is generated by the electrical resistance of the raw material, heating the raw material and controlling the temperature.

The combined impedance of the LCR series circuit is expressed by the following equation (2).

[Math. 1]

$$\dot{Z} = R + j\left(\omega L - \frac{1}{\omega C}\right) \qquad \text{Equation (2)}$$

In Equation (2),

$\dot{Z}$ : Total impedance ($\Omega$)
R : Resistance impedance ($\Omega$)
$j\omega$ L : Coil impedance ($\Omega$)
$1/\omega$C : Capacitor impedance ($\Omega$)

In the equation (2), $\omega$L is also called inductive reactance $X_L$, and $1/\omega$C is also called capacitive reactance $X_C$ Here, since frequency f=$\omega/2\pi$, the inductive reactance $X_L$ and capacitive reactance $X_C$ change as frequency f changes. This changes the phase difference (phase angle) $\theta$ between the AC voltage and AC current. For example, when inductive reactance $X_L$ is larger or smaller than capacitive reactance $X_C$, the phase angle $\theta$ is expressed by the following equation (3). Furthermore, when inductive reactance $X_L$ and capacitive reactance $X_C$ are equal to each other, the phase angle $\theta$ is 0.
[Math. 2]

$$\theta = \tan^{-1}\left(\frac{\omega L - \dfrac{1}{\omega C}}{R}\right) \quad \text{Equation (3)}$$

As described above, when the frequency of the output voltage of the transistor is updated, the phase difference $\theta$ between the high frequency voltage and the high frequency current changes, and the high frequency voltage and the high frequency current applied to the heating coil 51 change. This changes the heating efficiency of the raw material, and the temperature distribution of the raw material changes.

When the skull melt method is used to grow crystals by directly heating the raw material by induction heating, the convection state of the melt of the raw material, in other words, the temperature distribution of the melt, is extremely important.

Here, when a magnetic field is applied to a conductive melt, Eddy currents are generated in the melt, inducing a magnetic field that cancels out the applied magnetic field. Therefore, the penetration depth $\delta$ of the applied magnetic field follows the equation (4) using the resistivity $\rho$ of the melt, the relative permeability $\mu$ of the melt, and the frequency f.

$$\delta = 5.03 \times (\rho/(\mu \times F))^{1/2} \quad \text{Equation (4)}$$

As shown in the equation (4), the penetration depth $\delta$ of the magnetic field depends on the frequency f. Therefore, in order to optimally control the temperature distribution of the melt by changing the penetration depth $\delta$ of the magnetic field, it is important to design the entire system, as well as the resonant frequency and driving frequency band of the system, taking into consideration the sizes of the basket, heating coil to be used and the like.

For example, when the frequency is low and the magnetic field penetrates deeply into the melt, the temperature of the raw material melt near the center of the melt where the seed crystal is placed exceeds the melting point, preventing crystal growth. On the other hand, by increasing the frequency and reducing the penetration depth of the magnetic field, the temperature of the raw material melt near the seed crystal falls below the melting point, allowing crystal growth to proceed.

[Current sensor 7]

The high-frequency heating device 1 according to this embodiment may include a current sensor 7. The current sensor 7 measures the amplitude and frequency of the AC current output by the transistor 109. In this embodiment, the current sensor 7 is preferably a Rogowski-type current sensor. Compared with an output current waveform measured by a winding-type current sensor, an output current waveform measured by a Rogowski-type current sensor has less noise. Therefore, by using the Rogowski-type current sensor 7, the phase difference can be accurately measured and controlled.

The output current waveform of the current sensor 7 is the waveform of the current flowing through the LCR circuit 5, and this is the current waveform after feedback. From the current sensor 7, a rectangular wave output voltage $V_{out}$ output from the transistor 109 and a sine wave output current flowing through the heating coil are output.

The output current waveform after feedback is input to the phase comparator 102, which compares the output current waveform with the above-mentioned reference waveform and outputs the phase difference therebetween.

The high-frequency heating device 1 according to this embodiment can reduce output fluctuations because it can control the drive frequency of the LCR circuit 5. The suppression of output fluctuations by the high-frequency heating device 1 is extremely effective for crystal growth of high-melting point compounds, which require precise control of temperature distribution.

(Basket)

The high-frequency heating device 1 according to this embodiment includes a basket (not shown). The basket is a coolable container having a cylindrical space inside, and raw materials can be placed inside. For example, a cooling path (not shown) through which cooling water flows is arranged inside the basket, and the basket is cooled by the cooling water flowing through the cooling path. The basket is made of a material with high thermal conductivity. Examples of the material for the basket include copper, silver, aluminum, and iron. Since the basket is made of a material with high thermal conductivity, the raw materials placed inside the basket are cooled by the basket.

The raw material is heated by the heating coil 51 and melted, but near the water-cooled basket, the molten liquid of the raw material solidifies and sinters because the temperature is low. This sintered body (skull) holds the melt. The temperature of the raw material melt is controlled by controlling the frequency of the high-frequency voltage applied to the heating coil 51 disposed outside the basket.

(Rod)

The high-frequency heating device 1 according to this embodiment preferably includes a rod (not shown). The rod is moved in the opposite direction to the melt to grow the crystal. The rod is provided inside the basket such that one end can be inserted from above. A seed crystal is provided at the one end of the rod, and the seed crystal is disposed at the center of the heating coil 51 on the horizontal plane. The rod is capable of moving from one end to the other end relative to the basket.

Since the temperature of the melt at the center of the basket is controlled to be close to the melting point by the high-frequency heating device 1, the seed crystal is pulled upward by the rod, whereby the melt is cooled and crystal growth proceeds to produce a crystal. The pulling speed (movement speed) of the rod is, for example, 0.1 to 100 (mm/hour), preferably 1 to 50 (mm/hour), and more preferably 3 to 20 (mm/hour).

(Raw materials)

The raw material is a high melting point compound, for example, a high melting point oxide, such as gallium oxide ($\beta$-$Ga_2O_3$), gadolinium aluminum gallium garnet ($Gd_3(Al,Ga)_5O_{12}$), lithium tantalate ($LiTaO_3$), lithium niobate ($LiNbO_3$), yttrium oxide ($Y_2O_3$), and the like. In addition to the above, the high melting point oxide may include high melting point oxides containing various elements.

As described above, oxides have a large resistivity $\rho$, so a high frequency f must be applied to heat the oxide raw material, but the high-frequency heating device 1 can output a frequency f on the order of several hundred kHz to 10 MHz, making it possible to heat the oxide raw material. In addition, because it can output a high frequency f, it is possible to increase the diameter of the molten liquid inside the raw material, and therefore the diameter of the crystal can be increased.

Furthermore, since the high frequency heating device 1 is capable of adjusting the frequency, the temperature of the melt near the seed crystal can be brought close to its melting point, thereby facilitating crystal growth.

(Controller)

The high-frequency heating apparatus 1 may include a controller (not shown). The controller controls various operations of the high-frequency heating apparatus 1. For example, the controller controls the lifting speed of the rod and the cooling capacity of the basket.

(Rotation mechanism)

Moreover, it is preferable that the high frequency heating device 1 further includes a rotation mechanism (not shown) for rotating at least either the rod or the raw material around the central axis of the rod in the extending direction as the rotation axis. The rotation mechanism rotates the rod relative to the raw material, thereby achieving the effect of mitigating non-uniformity in the temperature distribution in the device and in the melt.

(Operation)

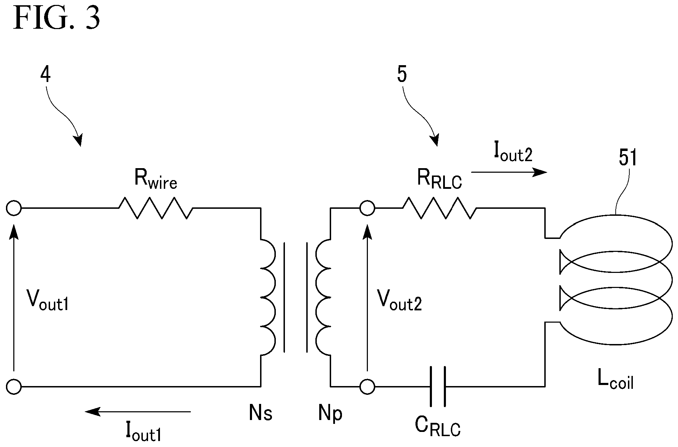

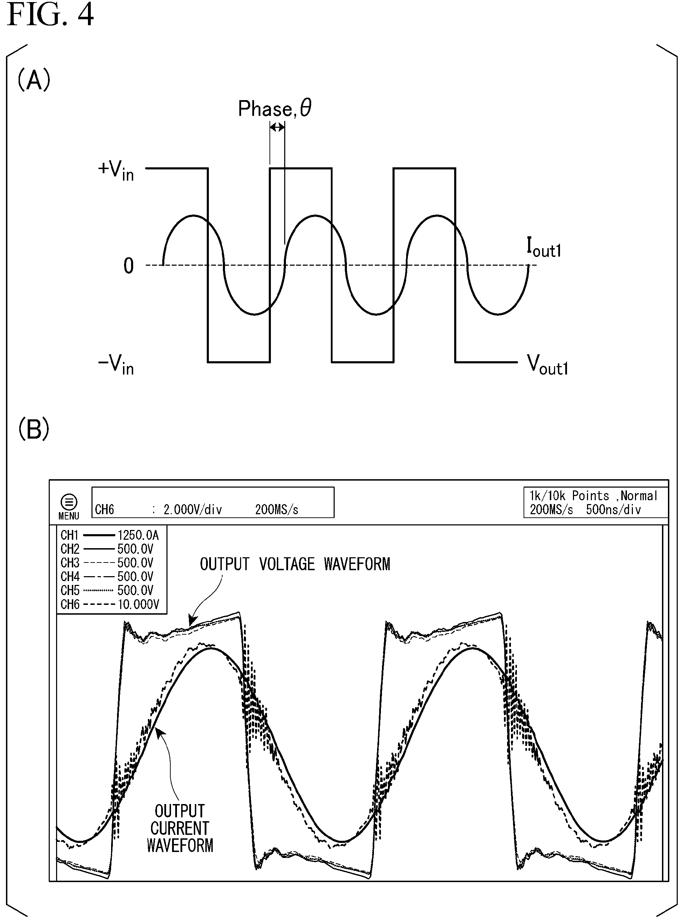

Here, the operation of frequency control of the high-frequency heating device 1 will be described with reference to Figures 1, 3 and 4. Figure 3 is a diagram showing an outline of a circuit including a part of the circuit of the inverter 4, the LCR circuit 5 and the heating coil 51. The panel (A) of Figure 4 is a conceptual diagram for explaining the phase difference between the output current waveform and the reference waveform, and the panel (B) of Figure 4 is a waveform diagram showing an example of the output current waveform and the output voltage waveform.

As shown in Figure 3, a high-frequency voltage $V_{out1}$ (high-frequency rectangular wave) having a drive frequency output from the transistor 109 of the inverter 4 is applied to the LCR circuit 5. When the high frequency rectangular wave is applied to LCR circuit 5, an induced voltage $V_{out2}$ is generated in LCR circuit 5, causing a sine wave high frequency current $I_{out2}$ to flow through heating coil 51. This is because the harmonics of the high frequency voltage rectangular wave are filtered by LCR circuit 5, leaving only a sine wave with the frequency of the rectangular wave, which is the fundamental wave. The sine wave high frequency current $I_{out2}$ is input to current sensor 7, which outputs an output current waveform.

As shown in the panel (A) of Figure 4, when this output current waveform $I_{out1}$ and a high-frequency voltage waveform (reference waveform) generated by an arbitrary waveform generator 106 are input to a phase comparator 102, a voltage (output voltage waveform) corresponding to the phase difference θ between the output current waveform and the reference waveform is output from the phase comparator 102. The voltage corresponding to this phase difference is passed through a low-pass filter 103, converted into a digital signal by an A/D converter 104, and input to a computer 105, where the phase difference between the high-frequency current (output current waveform) and the output voltage waveform is detected. The output current waveform and the output voltage waveform are shown, for example, in the panel (B) of Figure 4.

Furthermore, the computer 105 compares the detected phase difference with a set threshold, and when the phase difference crosses the threshold, updates the drive frequency by a certain amount of frequency fluctuation, and inputs a signal for generating the updated drive frequency to the arbitrary waveform generator 106. The arbitrary waveform generator 106 generates a square wave of the updated frequency and controls the gate voltage of the transistor 109 of the inverter 4. The transistor 109 outputs a high-frequency voltage of the updated drive frequency and applies it to the LCR circuit 5.

In the manner described above, feedback control is performed. That is, in at least one of the melting step and the crystal growing step, the driving frequency of the high frequency voltage applied to the LCR circuit 5 is controlled based on the phase difference between the high frequency voltage and the high frequency current, or the phase difference between the gate voltage of the transistor that determines the frequency of the wave heating device and the high frequency current. In this manner, the temperature distribution of the raw material melt is controlled.

In this manner, stable heating control is possible by controlling the frequency of the high frequency magnetic field through feedback so that the phase difference between the output current waveform and the output voltage waveform falls within a predetermined range.

Furthermore, by configuring a high-frequency heating device with a phase difference detector that detects the phase difference between the high-frequency voltage and high-frequency current, a frequency controller that compares the detected phase difference with a threshold value and feeds it back to the heating frequency, an inverter that generates the frequency-controlled high-frequency voltage, and an LCR circuit that performs induction heating, the phase difference between the high-frequency voltage and high-frequency current can be detected and the frequency can be controlled.

In the above-described high-frequency heating device, the gate voltage of the transistor in the inverter is controlled by software using a frequency controller including a computer to generate high-frequency waves, thereby achieving stable feedback control at low cost.

<Crystal producng apparatus>

A crystal producing apparatus according to an embodiment of the present invention is a crystal producing apparatus for growing crystals using a molten material, and includes a high-frequency heating device having an LCR circuit and a coolable basket for holding the material, and adjusts the temperature of the melt by controlling the frequency of a high-frequency voltage applied to the LCR circuit including a heating coil disposed outside the basket. For example, the high-frequency heating device 1 described above may be used as the high-frequency heating device having an LCR circuit.

<Crystal production method>

A crystal production method according to one embodiment of the present invention is a crystal production method using a high-frequency heating device equipped with an LCR circuit having a heating coil for heating a raw material, and includes a melting step and a crystal growing step of the raw material to be grown as a crystal, and is characterized in that in at least one of the melting step and the crystal growing step, the driving frequency of the induction heating is controlled to perform heating. The melting step and the crystal growing step may be performed, for example, by the operation of the high-frequency heating device 1 as described above. Therefore, the melting step is a step of melting the raw material placed inside the heating coil by applying a high-frequency voltage generated by the high-frequency heating device to the LCR circuit to generate a high-frequency current, and the crystal growing step is a step of contacting a seed crystal with the raw material melt in which the raw material is molten to grow the crystal. And, in at least one of the melting step and the crystal growing step, it is preferable to control the driving frequency of the high-frequency voltage applied to the LCR circuit based on the phase difference between the high-frequency voltage and the high-frequency current to control the temperature distribution of the raw material melt.

In the crystal production method according to the present embodiment, the driving frequency is preferably shifted to the higher or lower frequency side than the resonance frequency of the LCR circuit. More preferably, it is shifted to the higher frequency side. This allows for more stable heating control.

Furthermore, it is preferable that the driving frequency used in the crystal growing step is farther away from the resonance frequency of the LCR circuit than the driving frequency used in the melting step. This is because the melting step requires a large heat capacity to melt the raw material from a solid state, while the crystal growing step requires more precise control of the heating. Being closer to the resonance frequency allows for high thermal efficiency and can handle a large heat capacity, while being farther away from the resonance point makes it easier to perform more precise control. This allows for more stable heating and allows the temperature distribution of the solution to be the desired temperature distribution. As a result, more stable crystal growth is achieved.

Furthermore, it is preferable that the phase difference used in the crystal growing step is larger than that used in the melting step, so that a sufficient output to melt the raw material can be obtained in the melting step, and a stable temperature distribution can be achieved in the crystal growing step, resulting in more stable crystal growth.

Furthermore, in the feedback control, the frequency fluctuation amount to be changed when the phase difference is out of the threshold value is preferably smaller in the crystal growing step than in the melting step, which allows more stable crystal growth in the crystal growing step.

Although the present invention has been described above based on the embodiment of the present invention, the present invention is not limited thereto. The above is merely an example, and anything that has substantially the same configuration as the technical idea described in the claims of the present invention and exhibits similar effects is included in the technical scope of the present invention.

EXAMPLES

Next, examples of the present invention will be shown, but the conditions in the examples are merely examples of conditions adopted to confirm the feasibility and effects of the present invention, and the present invention is not limited to the conditions used in the following examples. Various conditions can be adopted in the present invention as long as they do not deviate from the gist of the present invention and achieve the object of the present invention.

<Example 1>

As a first embodiment, an example will be shown in which the drive frequency is controlled based on the phase difference between the high frequency voltage applied to an LCR circuit and the high frequency current flowing through the LCR circuit in a crystal growing step of a crystal production method using gallium oxide as a raw material.

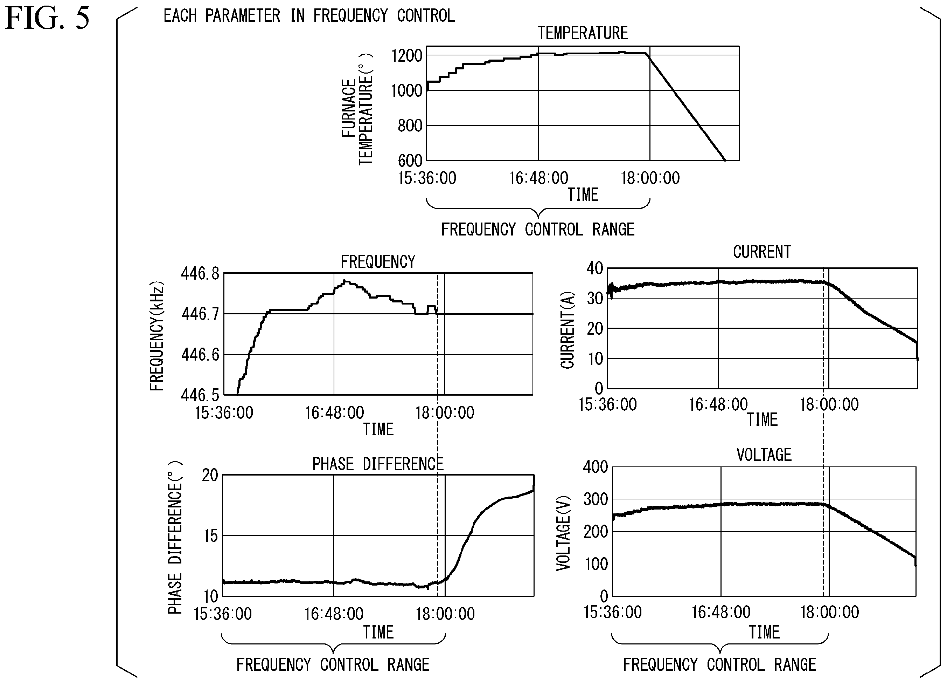

Figure 5 shows the changes over time in the temperature, drive frequency, phase difference between the high-frequency voltage and high-frequency current, the high-frequency voltage applied to the LCR circuit, and the high-frequency current flowing through the LCR circuit during the crystal growing step in which the drive frequency is controlled based on the above phase difference.

By controlling the drive frequency, the voltage applied to the LCR circuit and the current flowing through it are controlled, which allows for a stable crystal growth process.

<Example 2>

As Example 2, a process is shown in which the drive frequency is controlled based on the phase difference between the high frequency voltage applied to the LCR circuit and the high frequency current flowing through the LCR circuit in the melting step of the raw material in the crystal production method using gallium oxide as the raw material.

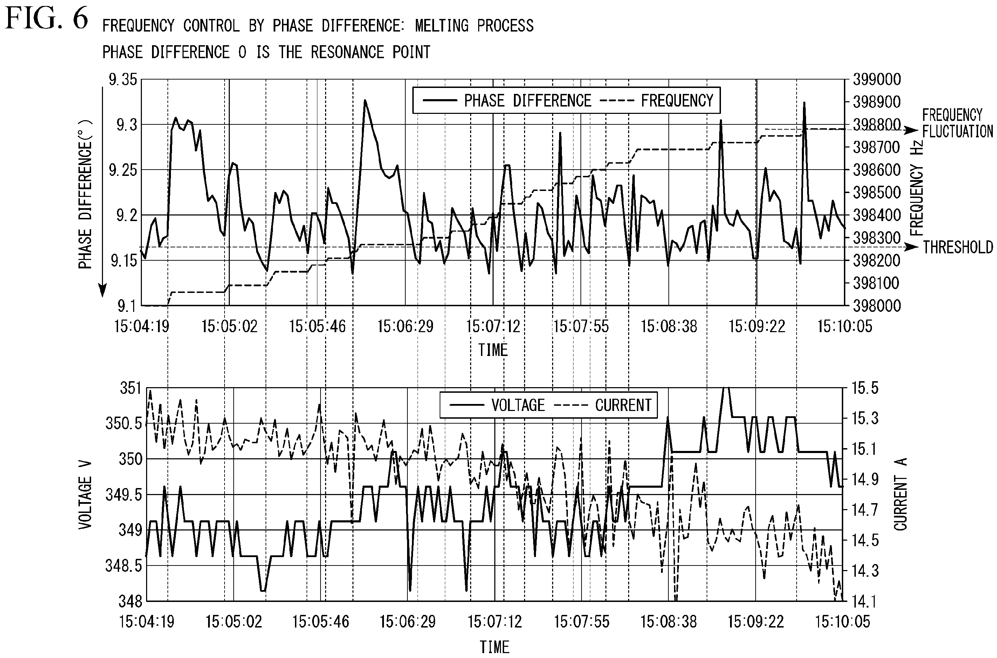

Figure 6 shows an example of controlling the drive frequency when the lower threshold of the phase difference is set to 9.17 degrees. In this process, the lower threshold is set to appropriately suppress overcurrent from flowing through the transistor and damaging it. At this time, the phase difference varies in the range of 9.15 to 9.33 degrees, and when the phase difference falls below the lower threshold of 9.17, the drive frequency is shifted to the high frequency side by the frequency fluctuation amount of 30 Hz.

The high frequency current flowing through the LCR circuit contains noise but has decreased from 15.3 A to 14.1 A, and the high frequency voltage applied to the LCR circuit contains noise but has increased from 349 V to 350.5 V Since the fluctuations in these currents and voltages are smaller than the change in phase difference, a method of monitoring the phase difference and controlling the frequency allows for more precise control of the temperature distribution than current and voltage control.

<Example 3>

As a third embodiment, a process is shown in which the drive frequency is controlled based on the phase difference between the high frequency voltage applied to an LCR circuit and the high frequency current flowing through the LCR circuit in the crystal growing step of a crystal production method using gallium oxide as a raw material.

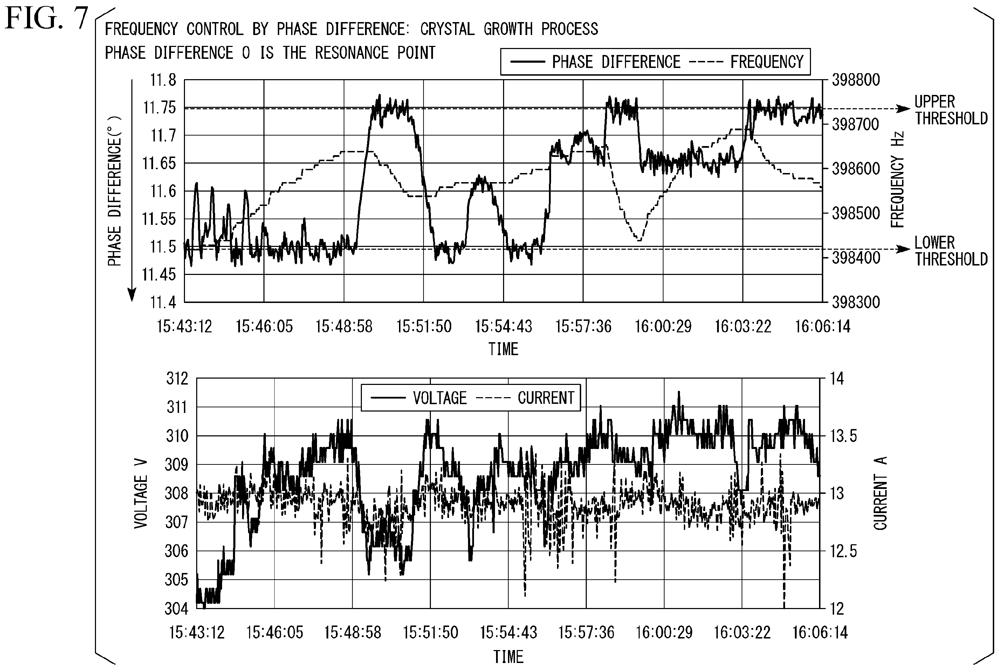

In Figure 7, the lower threshold is set to 11.5 degrees and the upper threshold is set to 11.75 degrees, and when the phase difference falls below the lower threshold, the drive frequency is increased, and when the phase difference rises above the upper threshold, the drive frequency is decreased to optimize the temperature. The frequency fluctuation amount at this time is 10 Hz.

While the current and voltage contain a lot of noise, the phase difference exhibits relatively stable changes.

Comparing Example 2 and Example 3, the phase difference in the crystal growing step is larger than the phase difference in the raw material melting step. Also, the amount of frequency fluctuation is smaller in the crystal growing step than in the melting step. This is because in the raw material melting step, there is a large increase in latent heat and volume of the melt, so it is necessary to increase the output, and the phase difference is made smaller and the driving frequency is made closer to the resonance frequency. Also, in the raw material melting step, the resistivity difference between the solid and the liquid, the change in the melt volume, the change in inductance, and the change in the resonance frequency are large, so the amount of frequency fluctuation is increased. In the crystal growing step, stable and highly accurate temperature control is required. Therefore, by increasing the phase difference and moving the driving frequency away from the resonance frequency, a stable output can be obtained. Also, since the amount of frequency fluctuation is small, more detailed control is possible.

REFERENCE SIGNS LIST

1. High frequency heating device
2 Phase difference detection part
3. Frequency controller
4 Inverter
5. LCR circuit
7 Current sensor
51 Heating coil
102 Phase comparator
103 Low-pass filter
104 A/D converter
105 Computer
106 Arbitrary Waveform Generator
107 Thyristor regulator
108 Step-up transformer
109 Transistor

**Claims**

1.    A crystal production method using a high-frequency heating device equipped with an LCR circuit including a heating coil for heating a raw material, the crystal production method comprising:

a melting step of melting a raw material; and
a crystal growing step of growing a crystal, wherein
heating is performed by controlling a driving frequency of induction heating in at least one of the melting step and the crystal growing step.

2.    The crystal production method according to claim 1, wherein

the melting step is a step of heating and melting the raw material placed inside the heating coil by a high-frequency magnetic field generated by applying a high-frequency voltage and a high-frequency current generated by the high-frequency heating device to the heating coil included in the LCR circuit,
the crystal growing step is a step of growing a crystal by contacting a seed crystal with a raw material melt in which the raw material is molten, and
at least in one of the melting step and the crystal growing step, a temperature distribution of the raw material melt is controlled by controlling the driving frequency of the high-frequency voltage applied to the LCR circuit based on a phase difference between the high-frequency voltage and the high-frequency current, or a phase difference between a gate voltage of a transistor that determines the frequency of the high-frequency heating device and the high-frequency current.

3.    The crystal production method according to claim 2, wherein in the melting step, the raw material is heated by the high frequency magnetic field to melt the raw material.

4. The crystal production method according to any one of claims 1 to 3, wherein the drive frequency is shifted to a higher or lower frequency side with respect to a resonant frequency of the LCR circuit.

5. The crystal production method according to any one of claims 1 to 3, wherein the driving frequency used in the crystal growing step is farther away from a resonant frequency of the LCR circuit than the driving frequency used in the melting step.

6. A high-frequency heating device comprising, at least:

   a phase difference detector;
   a frequency controller;
   an inverter; and
   an LCR circuit, wherein
   the phase difference detector is configure to detect the phase difference between the high-frequency voltage generated by the frequency controller and the high-frequency current flowing through the LCR circuit, or the phase difference between the high-frequency voltage applied to the LCR circuit and the high-frequency current flowing through the LCR circuit, and
   the inverter is configured to update the drive frequency of the high-frequency voltage based on the phase difference to control the current of the LCR circuit.

7. The high-frequency heating device according to claim 6, wherein the phase difference detector includes a phase frequency detector, an analog phase detector, or a digital phase detector that detects the phase difference.

8. The high frequency heating device according to claim 6 or 7, wherein

   the inverter includes a plurality of transistors in parallel that operate as switching elements, and
   the frequency controller is configured to generate a reference waveform to be updated by the frequency controller based on the phase difference detected by the phase difference detector, and control the transistor with the voltage of the reference waveform to be updated, thereby generating a high frequency voltage and a high frequency current whose drive frequency to be applied to the LCR circuit is updated.

9. The high frequency heating device according to claim 6 or 7, wherein the drive frequency of the high frequency voltage is 20 MHz or less.

10. The high frequency heating device according to claim 6 or 7 comprising:

    a Rogowski type or a wound type current sensor, wherein
    the high frequency current flowing through the LCR circuit is detected by the current sensor.

11. A crystal producing apparatus for growing a crystal using a raw material melt, comprising:

    a high-frequency heating device having an LCR circuit containing a heating coil for heating the raw material; and
    a coolable basket for holding the raw material, wherein
    a temperature of the melt is controlled by controlling a frequency of a high-frequency voltage applied to the heating coil arranged outside the basket.

12. The crystal producing apparatus according to claim 11, comprising:

    a rod having one end insertable into an inside of the basket from above, wherein
    a seed crystal is held at the one end, and
    the rod is configured to be movable relative to the basket from the one end to another end of the rod.

13. The crystal producing apparatus according to claim 12, comprising a rotation mechanism configured to rotate at least either the rod or the raw material about a central axis of the rod in the extension direction as a rotation axis.

# FIG. 1

HIGH-FREQUENCY HEATING DEVICE 1

# FIG. 2

(A)

(B)

FIG. 3

# FIG. 4

(A)

(B)

FIG. 5

EACH PARAMETER IN FREQUENCY CONTROL

FIG. 6 FREQUENCY CONTROL BY PHASE DIFFERENCE: MELTING PROCESS
PHASE DIFFERENCE 0 IS THE RESONANCE POINT

EP 4 610 410 A1

FIG. 7

FREQUENCY CONTROL BY PHASE DIFFERENCE: CRYSTAL GROWTH PROCESS
PHASE DIFFERENCE 0 IS THE RESONANCE POINT

EP 4 610 410 A1

**EP 4 610 410 A1**

## INTERNATIONAL SEARCH REPORT

| International application No. |
|---|
| **PCT/JP2023/038408** |

### A. CLASSIFICATION OF SUBJECT MATTER

*C30B 15/14*(2006.01)i; *H05B 6/06*(2006.01)i
FI: C30B15/14; H05B6/06 371; H05B6/06 386

According to International Patent Classification (IPC) or to both national classification and IPC

### B. FIELDS SEARCHED

Minimum documentation searched (classification system followed by classification symbols)

C30B15/14; H05B6/06

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII); Science Direct; Wiley Online Library

### C. DOCUMENTS CONSIDERED TO BE RELEVANT

| Category* | Citation of document, with indication, where appropriate, of the relevant passages | Relevant to claim No. |
|---|---|---|
| X | 富田健稔ほか, スカルメルト法によるルツボフリーなβ-Ga2O3単結晶の新規育成手法, 第69回応用物理学会春季学術講演会 講演予稿集, March 2022, (TOMIDA, Taketoshi et al. Development of crucible-free β-Ga2O3 crystal growth based on skull melting method.), non-official translation (Lecture Preprints of the 69th JSAP Spring Meeting) in particular, 3rd paragraph onwards | 1, 4, 11-13 |
| Y | | 1-4, 6-13 |
| A | | 5 |
| X | JP 2018-191426 A (C & A CORP) 29 November 2018 (2018-11-29) claims, paragraphs [0016]-[0026], fig. 1, 4 | 6-10 |
| Y | | 1-4, 6-13 |
| A | | 5 |
| A | JP 54-106080 A (TOKYO SHIBAURA ELECTRIC CO) 20 August 1979 (1979-08-20) entire text, all drawings | 1-13 |

☑ Further documents are listed in the continuation of Box C.    ☑ See patent family annex.

| | | |
|---|---|---|
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 January 2024** | **30 January 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

21

## INTERNATIONAL SEARCH REPORT

International application No.

**PCT/JP2023/038408**

**C.    DOCUMENTS CONSIDERED TO BE RELEVANT**

| Category* | Citation of document, with indication, where appropriate, of the relevant passages | Relevant to claim No. |
|-----------|-----------------------------------------------------------------------------------|----------------------|
| P, X | JP 2023-122837 A (UNIV TOHOKU) 05 September 2023 (2023-09-05)<br>entire text, all drawings | 1-13 |

Form PCT/ISA/210 (second sheet) (July 2022)

**INTERNATIONAL SEARCH REPORT**
Information on patent family members

International application No.

**PCT/JP2023/038408**

| Patent document cited in search report | | | Publication date (day/month/year) | Patent family member(s) | Publication date (day/month/year) |
|---|---|---|---|---|---|
| JP | 2018-191426 | A | 29 November 2018 | (Family: none) | |
| JP | 54-106080 | A | 20 August 1979 | (Family: none) | |
| JP | 2023-122837 | A | 05 September 2023 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022169953 A
- JP 2006312571 A
- US 4049384
- JP 60002876 A
- JP 2017061396 A
- JP 2018191426 A

**Non-patent literature cited in the description**

- **HIDEO AIDA et al.** Growth of $\beta$-Ga2O3 single crystals by the Edge-Defined, Film Fed Growth Method. *Jpn. Journal of Applied Physics*, 2008, vol. 47 (11), 8506-8509